Europäisches Patentamt

European Patent Office

Office européen des brevets

(19)

(11) **EP 0 862 061 B1**

(12) **EUROPEAN PATENT SPECIFICATION**

(45) Date of publication and mention
of the grant of the patent:
**15.01.2003 Bulletin 2003/03**

(51) Int Cl.$^7$: **G01R 31/312**, G01R 31/28

(21) Application number: **98103453.1**

(22) Date of filing: **27.02.1998**

(54) **Circuit board inspection apparatus and method**

Verfahren und Vorrichtung zum Prüfen von Leiterplatten

Procédé et dispositif de contrôle de cartes de circuit

(84) Designated Contracting States:
**DE FR GB**

(30) Priority: **28.02.1997 JP 4612797**

(43) Date of publication of application:
**02.09.1998 Bulletin 1998/36**

(73) Proprietor: **Nidec-Read Corporation**
**Uji-city, Kyoto 611-0041 (JP)**

(72) Inventor: **Yamashita, Munehiro**
**Uji-city, Kyoto 611-0041 (JP)**

(74) Representative:
**von Fischern, Bernhard, Dipl.-Ing. et al**
**Hoffmann - Eitle,**
**Patent- und Rechtsanwälte,**
**Arabellastrasse 4**
**81925 München (DE)**

(56) References cited:
**EP-A- 0 551 564        EP-A- 0 572 060**
**EP-A- 0 633 478        EP-A- 0 636 887**
**DE-A- 4 417 580        JP-A- 3 154 879**
**JP-A- 8 054 448**

## Description

The present invention relates to a circuit board inspection apparatus and method, and in particular, to the inspection of the continuity of wiring formed on a circuit board.

A method for contacting probes with both ends of a printed pattern is one of the methods for inspecting the continuity of a printed pattern formed on a printed circuit board. The continuity of the printed pattern can be inspected by checking whether a predetermined current flows when a voltage is applied between both probes.

This method, however, is difficult to apply to a pad section with a fine pitch in which the ends of adjacent printed patterns are located in close proximity to each other. That is, probes compatible with fine pitches are generally expensive and a highly accurate and difficult technique for aligning probes with a substrate must be used during inspections. In addition, since the probes are placed into contact with pads, the pads may be damaged.

One of the inspection methods that attempt to solve this problem uses anisotropic conducting rubber instead of the probes (Japanese Patent Application Laid Open No. 61-62877). This method enables the continuity of a printed pattern with a fine-pitch pad section to be inspected without using expensive probes compatible with fine pitches or damaging the pads.

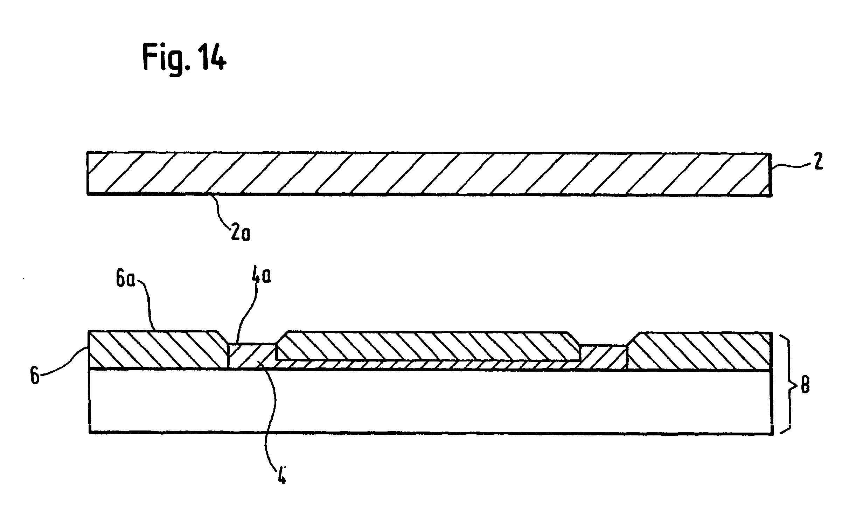

With a method using anisotropic conducting rubber 2, however, pressing the rubber 2 against a circuit board 8 may not allow the bottom surface 2a of the rubber 2 to abut the top surface 4a of a pad 4 if there is a resist 6 having a top surface 6a above the top surface 4a of the pad 4, as shown in Figure 14. This configuration results in poor contact during an inspection.

One of the methods that attempt to solve this problem uses a non-contact sensor (Japanese Patent Application Laid Open No. 4-244976 and Japanese Patent Application Laid Open No. 58-38874). This method enables a signal to be transmitted between the pads and the sensor despite the resists around the pads.

Since, however, the non-contact sensor using a sine-wave alternating current must execute filtering or include a wave detector to reduce the effects of noise such as hum components, approximately several tens of milliseconds were required to inspect a single printed pattern. If several thousand inspections are carried out for a single circuit board, several tens of seconds are required to inspect that circuit board.

On the other hand, there is a method for measuring a direct transient current in a non-contact manner to determine the acceptability of a printed pattern instead of the sine-wave alternating current (Japanese Patent Application Laid Open No. 3-154879). Such a method eliminates the need for a wave detector, thereby reducing the inspection time somewhat.

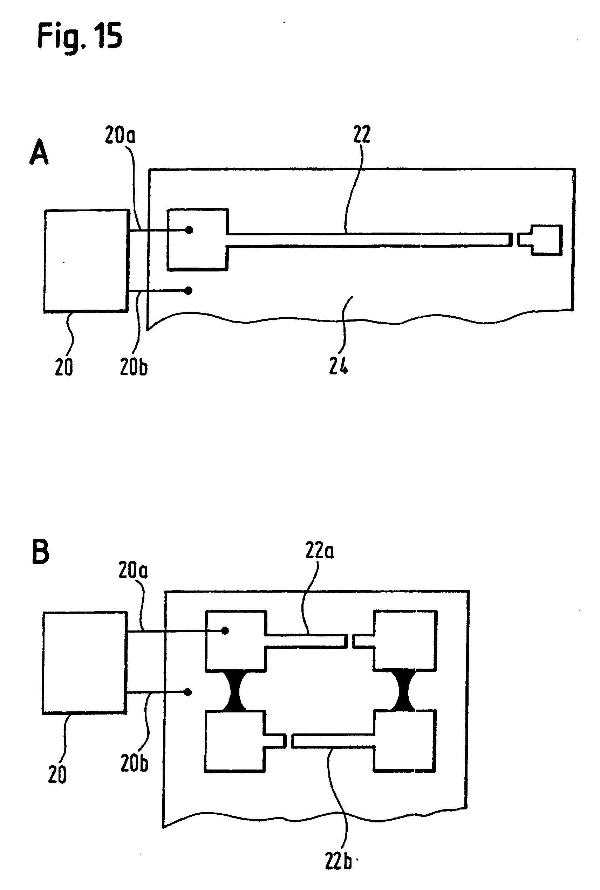

This inspection method connects terminals 20a and 20b of an inspection apparatus 20, a printed pattern 22, and a reference potential surface 24 formed to ensure insulation from the printed pattern 22, respectively, and applies a direct current to the terminal 20a for an inspection, as shown in Figure 15A. That is, this method determines the acceptability of the printed pattern 22 based on a transient current flowing through a capacitor formed between the printed pattern 22 and the reference potential surface 24.

If, however, the printed pattern 22 is open-circuited at a position remote from the terminal 20a, as shown in Figure 15A, this method may fail to detect this open-circuit. In addition, if both printed patterns 22a and 22b are open-circuited and short-circuited, this method may also fail to detect this condition.

In addition, due to the need to examine the capacity of the capacitor formed between the printed pattern 22 and the reference potential surface 24 as well as a steady-state current flowing between the terminals 20a and 20b, this method must wait for this capacitor with a relatively large capacity to be almost fully charged, which prevents significant reductions in the inspection time.

JP-854448 describes a system for substrate inspection having a non-contact voltage feeding apparatus. The feeding apparatus includes a feed control element having a laminated structure as a light probe. A voltage is applied to the light probe disposed on the feeding side of the circuit pattern to be inspected by irradiating the light probe with a laser beam. An electrostatic capacitance coupling under a non-contact system is provided on the detection side, and an electrical condition of the coupling is extracted from the circuit and a waveform processing is performed on the detected signals so as to make it possible to test respective conductive paths of the circuit pattern.

The use of capacitively coupled probes for circuit board testing is also known from EP-A-0551564 or DE-A-4417580, the latter of which discloses the preamble of claim 1.

EP-A-0633478 discloses a device for testing encased integrated circuit devices mounted on a circuit board. For this purpose, rectangular voltage pulses are provided to one or more pins of an encased integrated circuit device, while other pins of the circuit are grounded. The electric field generated inside the casing of the integrated circuit device is detected capacitively, where a measuring signal m(t) is output and compared to a threshold value. If the measuring signal is below the threshold, then a faulty connection is determined.

It is an object of this invention to provide an inexpensive and reliable circuit board inspection apparatus and method that requires only a short inspection time and that is applicable even to a densely wired circuit board.

This object is achieved by the apparatus of claim 1. Advantageous embodiments are described in the dependent claims.

According to this invention, the term "circuit board" refers to a substrate on which wiring can be or has been formed and is not limited in terms of its material, structure, shape, or sizes. The circuit board includes, for example, a glass epoxy circuit board, a film-like circuit board, and a package on which circuit elements such as a CPU are mounted. It also includes a composite circuit board comprising sockets on a glass epoxy circuit board and a circuit board on which circuit elements are mounted.

The term "wiring" refers to a conductor that is used to conduct electricity and is not limited in terms of its material, structure, shape, or sizes. This term is a concept including printed patterns, through-holes, and pins that are formed on the circuit board as well as the conducting section of electric cords, sockets, connectors, and pins attached to the circuit board.

The terms "one end of the wiring" or "the other end of the wiring" refer to a point of the wiring to or from which an inspection signal is input or output and it is not limited in terms of its material, structure, shape, or sizes. This term includes an electric connection point to which a different component is connected such as an inspection-end or a connector-connection-end of the printed pattern, a connection pin, a pad to which a bonding wire is connected, a pad to which a circuit element or a socket is connected, an insertion portion formed in a socket mounted on the circuit board, and an I/O end of a connector, as well as an arbitrary point within the wiring.

The term "coupling" refers to coupling two or more members together so that a signal can be transmitted among the members while they are insulated from one another. It also includes coupling by means of electrostatic capacity or inductance.

The term "signal" refers to a signal used for inspections and is a concept including either a voltage or a current. It also includes alternating currents such as sine waves, a direct signal, a rectangular and a triangular signals, and a pulse signal.

The expression "based on a voltage generated between the first and the second terminals" means that something is based on a voltage generated between the first and second terminals or a physical quantity corresponding to or associated with the voltage. Thus, this physical quantity includes not only the voltage but also a current corresponding to or associated with the voltage, and its integrated and differential values.

The term "detection of the continuity of the wiring" refers to a concept that includes the detection of an open-or a short-circuit in the wiring and the detection of the resistance value of wiring such as a semi-open-circuit.

The term "group" refers to a set composed of one or two or more elements.

The term "signal with rapid changes" refers to a signal such as a voltage or a current that is subjected to frequent changes per unit time, and it includes, for example, a direct signal having a step-like rising or falling edge, a triangular and a rectangular signal, and a pulse signal.

The term "electrode section" refers to a conductor constituting an electrode on the second electrode side when electrostatic capacity is used for coupling and is not limited in terms of its material, structure, shape, or size.

The circuit board inspection apparatus according to Claim 1 couples the second terminal to the other end of the wiring without contact. Thus, expensive probes that offer a fine pitch and that are otherwise required for a circuit board on which the other end of the wiring is densely disposed are not necessary. This configuration also avoids damage to the other end of the wiring. In addition, since anisotropic conducting rubber is not used, a signal can be transmitted between the other end of the wiring and the second terminal even if there is a resist at the other end of the wiring.

In addition, the continuity of the wiring is detected based on a voltage generated between the first terminal connected or coupled to one end of the wiring and the second terminal coupled to the other end of the wiring. Consequently, an open-circuit can be detected regardless of the position of the open-circuit on the wiring or the presence of a short-circuit in the wiring.

Furthermore, this circuit board inspection apparatus is characterized in that the predetermined signal has sharp rising or falling edges. Consequently, when the signal is delivered, the voltage generated between the first and the second terminals is rapidly changed in response to changes in this signal. As a result, these rapid changes can be detected to determine the continuity of the wiring in order to conduct inspections promptly. In addition, the apparatus and method is thus unlikely to be affected by noise.

In addition, only the other end of the wiring is coupled to the second terminal. Thus, if this coupling is capacitive, the coupling capacity is reduced substantially compared to the coupling of the second terminal to the overall wiring. This configuration reduces the time constant of the circuit through which a signal current flows during an inspection, thereby enabling the inspection time to be reduced further.

That is, even a densely wired circuit board can be inspected inexpensively, reliably, and promptly.

The circuit board inspection apparatus according to Claim 1 has the feature that the second terminal is capacitively coupled to the other end of the wiring. Consequently, reliable inspections can be conducted using a simple configuration.

The apparatus is also characterized in that it determines the continuity of the wiring based on the maximum voltage generated between the first and the second terminals after a signal used for the inspection has changed rapidly. The maximum voltage is generated almost simultaneously with a rapid change in the signal. As a result, the continuity of the wiring can be determined in a very short time.

The circuit board inspection apparatus can have the feature that the continuity of the wire identified by the second terminal and the selected first terminal by switching the first switch means.

Thus, the desired wire can be identified and inspected by connecting or coupling the relevant first terminal to one end of a plurality of wires to be inspected, and then switching the first switch means as required.

As a result, the first terminal or the inspected circuit board need not be moved during an inspection. Thus, very accurate inspections can be provided, the manufacturing costs of the apparatus can be reduced, and inspections can be automated easily.

The signal supplier may sequentially generate signals with rapid changes. This signal source can thus generate signals of an arbitrary pattern. As a result, these apparatuses can generate signals of a pattern compatible with the signal transmission characteristics of the first and second terminals, the signal transmission characteristic of the inspected circuit board, as well as enable the desired inspection speed and accuracy.

The circuit board inspection apparatus according to claim 2 is characterized in that it includes the signal source for generating direct signals and in that by sequentially switching the switch means, the signals with rapid signals are obtained from the direct signals generated by the signal source. Thus, the signal source may be a direct power supply. As a result, the configuration of the apparatus can be simplified.

The circuit board inspection apparatuses may have the feature that two or more second terminals are provided for each of two or more groups into which the plurality of other ends are divided, and are each coupled to one of the other ends belonging to the corresponding group.

That is, the second terminal is provided for each group, so those other ends belonging to one group and those belonging to another group can be selected separately. Thus, various circuit boards having irregular or complicated wiring can be inspected very accurately.

In addition, the electrostatic capacity formed between the second terminal and the other end of the wiring is shared by the plurality of second terminals. Thus, each of the second terminals has a correspondingly low electrostatic capacity. This configuration can reduce the time constant of the circuit through which a signal current flows during an inspection, thereby further reducing the inspection time.

The circuit board inspection apparatus may have the feature that it can be adapted to inspect a circuit board having wiring with a plurality of other ends coupled to one another, and in which the plurality of a second terminals are coupled to the plurality of other ends, respectively. This configuration allows the continuity of a plurality of other ends of the branched wire to be accurately detected.

The circuit board inspection apparatus may have the feature that the first and the second switch means are switched to detect the continuity of the wire identified by a selected first and a selected second terminals.

Consequently, by connecting or coupling the corresponding first terminal to one end of the plurality of wires to be inspected, coupling the corresponding second terminal to the other end of the plurality of wires to be inspected, and then switching the first and the second switch means as required, a desired wire can be identified and inspected.

As a result, the first or the second terminal or the inspected circuit board need not be moved during an inspection. Thus, very accurate inspections can be provided, the manufacturing costs of the apparatus can be reduced, and inspections can be easily automated.

The circuit board inspection apparatus may have the feature that the plurality of second terminals are integrated together to form a sensor module. Thus, this apparatus is easier to handle compared to the separate use of the plurality of second terminals. Positioning can be executed between the circuit board and the integrated sensor module, thereby increasing efficiency. Inspections can also be conducted in a short time.

The circuit board inspection apparatus according to Claim 6 is characterized in that the second terminal has a shield member around the electrode section. Thus, reliable inspections can be conducted even in an environment that is characterized by relatively high noise.

The present invention will be better understood from the following description of preferred embodiments that are described with reference to the figures, in which:

Figure 1 shows the configuration of a bare-board tester that is a circuit board inspection apparatus according to one embodiment of this invention.

Figure 2 shows the details of a printed pattern section 34 on an inspected circuit board 32.

Figure 3A is a plan view of a sensor module 50. Figure 3B is a perspective view of the bottom surface of the sensor module 50 as seen from above.

Figure 4A is a plan view schematically showing a sensor unit 52. Figure 4B is a cross-sectional view schematically showing the integral part of the sensor unit 52. Figure 4C is a bottom view schematically showing the sensor unit 52.

Figure 5A is a plan view schematically showing a sensor unit 52 according to another embodiment. Figure 5B is a cross-sectional view schematically showing the integral part of this sensor unit 52. Figure 5C is a bottom view schematically showing this sensor unit 52.

Figure 6A is a plan view schematically showing a sensor unit 52 according to yet another embodiment. Figure 6B is a cross-sectional view schematically showing the integral part of this sensor unit 52. Figure 6C is a bottom view schematically showing this sensor unit 52.

Figure 7A schematically shows a switch section SW1. Figure 7B schematically shows a switch section SW2.

Figure 8 illustrates signal processing.

Figure 9 is a timing chart showing signal processing.

Figure 10 is a timing chart showing another example of signal processing.

Figure 11A shows a signal output from a signal source 46 in the example in Figure 10. Figure 11B shows a signal output from the signal source 46 in yet another example.

Figure 12 shows the configuration of a bare-board tester that is a circuit board inspection apparatus according to another embodiment of this invention.

Figure 13A is a plan view of a sensor module 90. Figure 13B is a cross-sectional view of the integral part of the sensor module 90. Figure 13C is a bottom view of the sensor module 90.

Figure 14 illustrates an example of a conventional inspection of the continuity of printed patterns.

Figure 15A illustrates another example of a conventional inspection of printed patterns. Figure 15B illustrates yet another example of a conventional inspection of printed patterns.

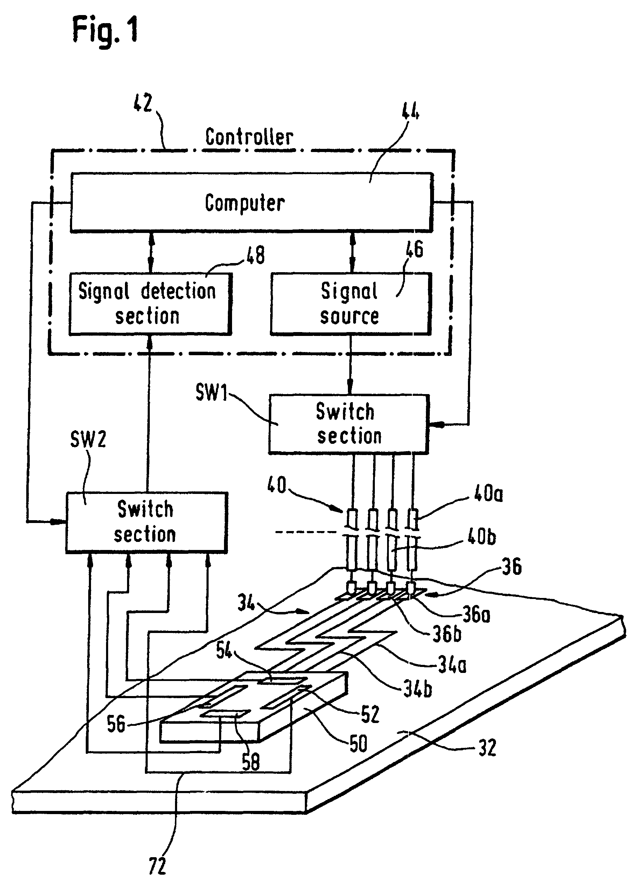

Figure 1 shows a bare-board tester that is a circuit board inspection apparatus according to one embodiment of the present invention. This bare-board tester inspects the continuity of printed patterns on a printed circuit board (a bare-board) before circuit elements are mounted on the board.

An example of an inspected circuit board is described. A plurality of printed patterns 34a, 34b, ... on the circuit board 32 is collectively called a printed pattern section 34. Pads 36a, 36b, ... are formed at one end of the printed patterns 34a, 34b, ... and collectively called a pad section 36.

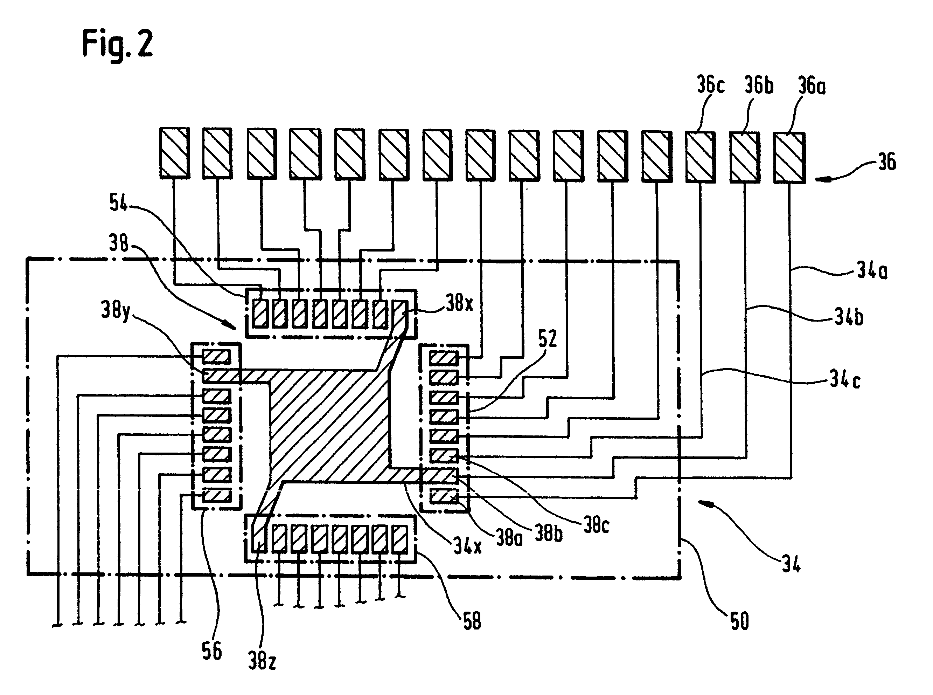

Figure 2 shows the printed pattern section 34 in detail. Pads 38a, 38b, ... are formed at the other ends of the printed patterns 34a, 34b, ... and collectively called a pad section 38. The pad section 38 shown in Figure 2 is called a QFP pattern on which QFPs (thin, square quad flat packages) are mounted. Thus, the pitch at which the pads 38a, 38b, ... are arranged is very small. In addition, in this QFP pattern, the pad 38b and the pads 38x, 38y, and 38z are connected together by the printed pattern 34x to form a ground line.

Referencing back Figure 1, the bare-board tester includes probes 40a, 40b, ... that are a plurality of first terminals connected to the pads 36a, 36b, ... on the circuit board 32. The plurality of probes 40a, 40b, ... are collectively called a probe section 40.

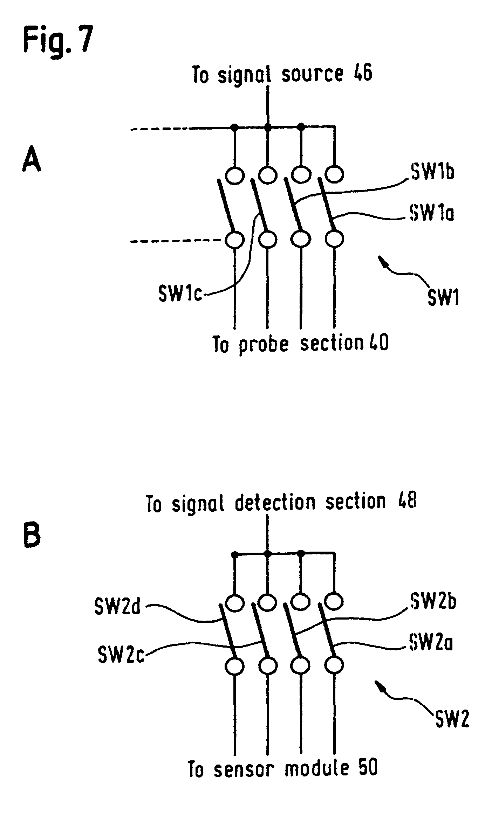

An inspection signal generated by a signal source 46 is delivered to a switch section SW1 that is a first switch means. Figure 7A schematically shows the switch section SW1. The switch section SW1 includes a plurality of switches SW1a, SW1b, ... Each switch is turned on/off in response to an instruction from a computer 44 to transmit a signal provided by the signal source 46 to a desired probe in the probe section 40, for example, the probe 40a, as shown in Figure 1 (in this case, only the switch SW1a is turned on).

The signal transmitted to the probe 40a is provided to the pad 38a (see Figure 2) of the pad section 38 via the pad 36a of the pad section 36 and the printed pattern 34a in the printed pattern section 34 which are connected to the probe 40a.

A sensor module 50 is located on the pad section 38 on the circuit board 32. The sensor module 50 is coupled to the pad section 38 in order to obtain a signal from the pad section 38 and to supply it to a switch section SW2 that is a second switch means.

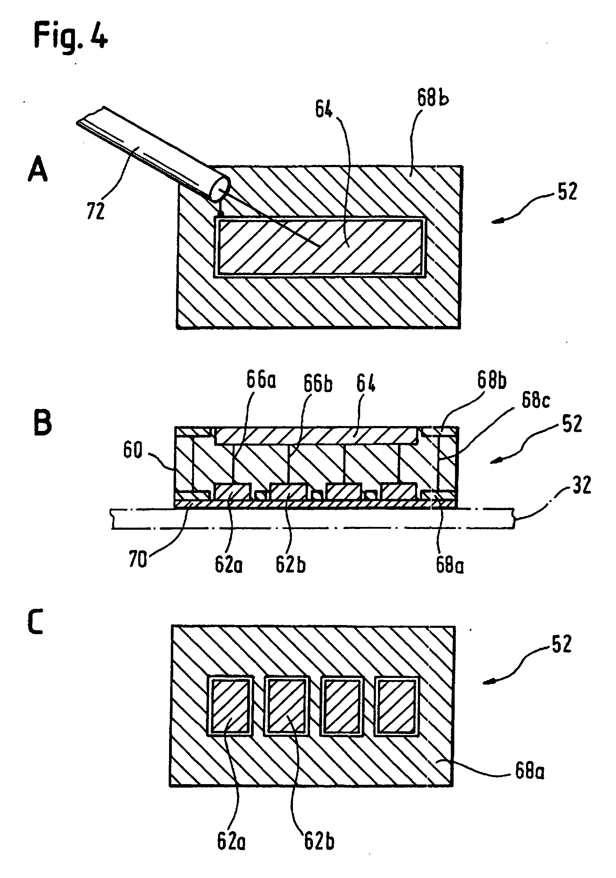

The sensor module 50 comprises four integrally formed sensor units 52, 54, 56, and 58 as shown in Figure 2. Each sensor unit corresponds to a second terminal. According to this embodiment, the sensor module 50 is composed of a circuit board 60 (see Figure 4B) that is manufactured through a process similar to the inspected circuit board 32.

Figures 4A, 4B, and 4C schematically shows the sensor unit 52 constituting part of the sensor module 50. In the example in Figure 2, the sensor unit 52 corresponds to the eight pads 38a, 38b, ... (these eight pads form one group) but is shown to correspond to four pads in Figures 4A, 4B, and 4C for case of understanding.

Figure 4A is a plan view of the sensor unit 52. Figure 4B is a cross sectional view showing an integral part. Figure 4C is a bottom view. As shown in Figures 4B and 4C, electrode plates 62a, 62b, ... constituting an electrode section are independently provided on the bottom surface of the circuit board 60. An insulating film 70 is formed to cover the electrode plates 62a, 62b, ... .

The electrode plates 62a, 62b, ... are located opposite to the pads 38a, 38b, ... (see Figure 2) of the pad section 38 of the inspected circuit board 32 that corresponds to the sensor unit 52 in order to form a group. The electrode plate is formed to have almost the same shape as each pad. Thus, for example, the electrode 62a and insulating film 70 of the sensor unit 52 join the pad 38a of the inspected circuit board 32 to form a capacitor. This is true of the other electrode plates 62b, ... .

As shown in Figures 4B and 4A, a connection plate 64 that serves as a connection conducting section is provided on the top surface of the circuit board 60. The connection plate 64 is electrically connected to the electrode plates 62a, 62b, ... via through-holes 66a, 66b, ... Thus, the connection plate 64 of the sensor unit 52 is capacitively coupled to the group of pads 38a, 38b, ... described above. As shown in Figure 4A, the connection plate 64 is connected to the switch section SW2 via a connection cord 72. The connection plate 64 and the through-holes 66a, 66b, ... correspond to a connection means.

In addition, as shown in Figures 4A, 4B, and 4C, shield films 68a and 68b that are shield members are formed on the bottom and top surfaces of the circuit board 60, and connected to each other via a through-hole 68c. A ground potential is applied to the shield films 68a and 68b.

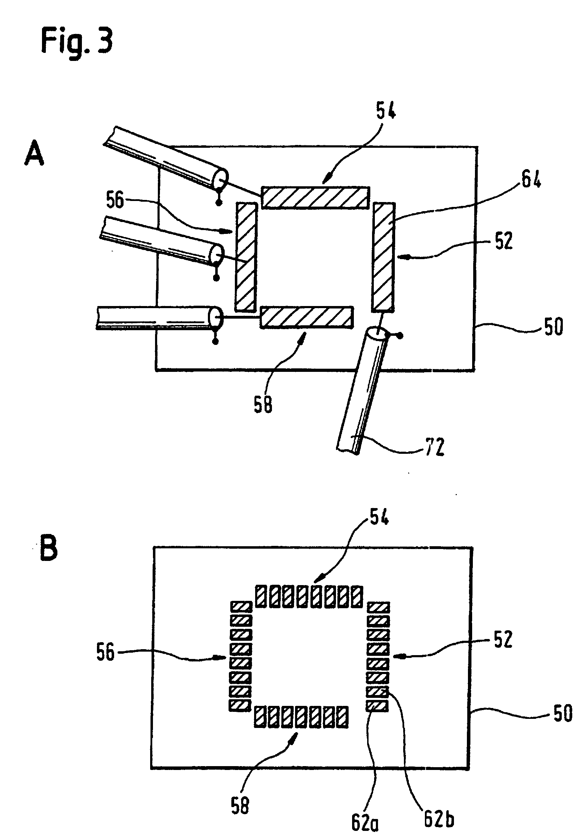

The sensor units 54, 56, and 58 (see Figure 2) constituting the other parts of the sensor module 50 have a similar configuration. Figure 3A shows a plan view of the sensor module 50. Figure 3B is a perspective view of the bottom surface of the sensor module 50 as seen from above.

Figure 7B schematically shows the switch section SW2. The switch section SW2 comprises four switches SW2a, SW2b, SW2c, and SW2d. Each switch is turned on/off in response to an instruction from the computer 44 (see Figure 1) to supply a signal detection section with a signal from a desired one of the four sensor units 52, 54, 56, and 58 constituting the sensor module 50, for example the sensor unit 52 (in this case, only the switch SW2a is turned on).

The signal provided by the desired sensor unit 52 is subjected to a predetermined process in the detection section 48 and then delivered to the computer 44, as shown in Figure 1. Based on the transmitted signal, the computer 44 determines the continuity of a printed pattern selected by the switch sections SW1 and SW2 (in the above example, the printed pattern 34a). The computer 44, the signal source 46, and the signal detection section 48 constitute a controller 42.

By designing the sensor module 50 of the four sensor units 52, 54, 56, and 58 so that a signal can be independently obtained from each sensor unit in this manner, the following advantages can be obtained. As described above, in the pad section 38 (the QFP pattern) of the printed pattern section 34 shown in Figure 2, the pad 38b and the pads 38x, 38y, and 38z are connected together by the printed pattern 34x to form a ground line.

Thus, by using the switch section SW1 to select the pad 36b and using the switch section SW2 to select the sensor unit 54 in order to inspect the continuity, it can be determined whether the printed pattern 34x is open-circuited between the pad 38b and the pad 38x.

By making the sensor module of the plurality of sensor units so that a signal can be independently obtained from each sensor unit in this manner, complicated or irregular printed patterns can be inspected accurately.

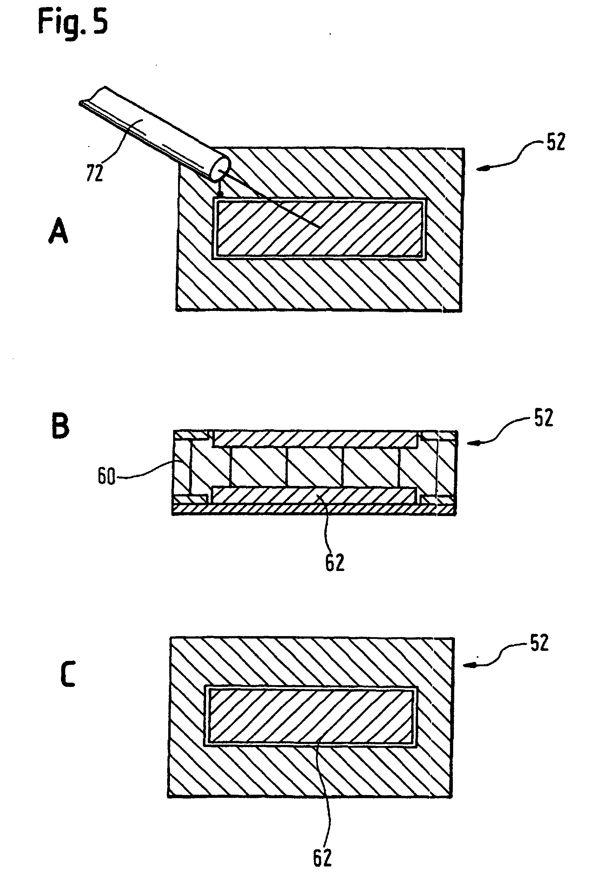

Although the above embodiment provides the plurality of electrode plates 62a, 62b, ... on the bottom surface of the circuit board 60 of the sensor unit 52, as shown in Figures 4B and 4C, a single large electrode plate 62 may be provided on the bottom surface of the circuit board 60 as shown in Figures 5A, 5B, and 5C. That is, the single large electrode plate 62 of the sensor unit 52 is coupled to the group of pads 38a, 38b, ... (see Figure 2) corresponding to the sensor unit 52.

This configuration is advantageous because the variation in the electrostatic capacity generated between the electrode plate 62 and the group of pads 38a, 38b, ... shown in Figure 2 is relatively small even if these components are only roughly aligned with each other.

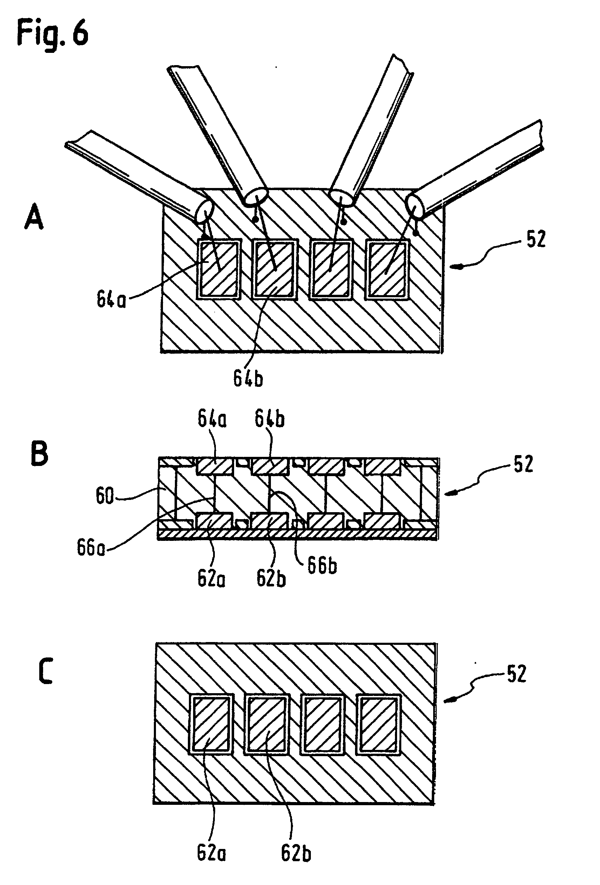

The above embodiment connects the plurality of electrode plates 62a, 62b,... to the single connection plate 64 to allow all the plurality of pads 38a, 38b, ... corresponding to the sensor unit 52 shown in Figure 2 to be subjected to a single signal processing, as shown in Figures 4B and 4A. A plurality of connection plates 64a, 64b, ... may be provided on the top surface of the circuit board 60 and connected to the electrode plates 62a, 62b, ..., respectively, via the through-holes 66a, 66b, ... to obtain a signal from the connection plates 64a, 64b, ..., as shown in Figure 6A, 6B, and 6C.

In this configuration, the plurality of pads 38a, 38b, ... shown in Figure 2 can be individually subjected to signal processing. This enables more delicate processing to allow the apparatus to inspect more complicated printed patterns. In this case, the pads 38a, 38b, ... form individual group. That is, each group is composed of only a single pad.

In addition, although the above embodiment integrates the four sensor units 52, 54, 56, and 58 into the sensor module 50, these sensor units may be separately formed. The integration, however, allows the plurality of sensor units to be handled easily compared to the separation of the units. In addition, the integral sensor module 50 can be more efficiently positioned on the circuit board 32.

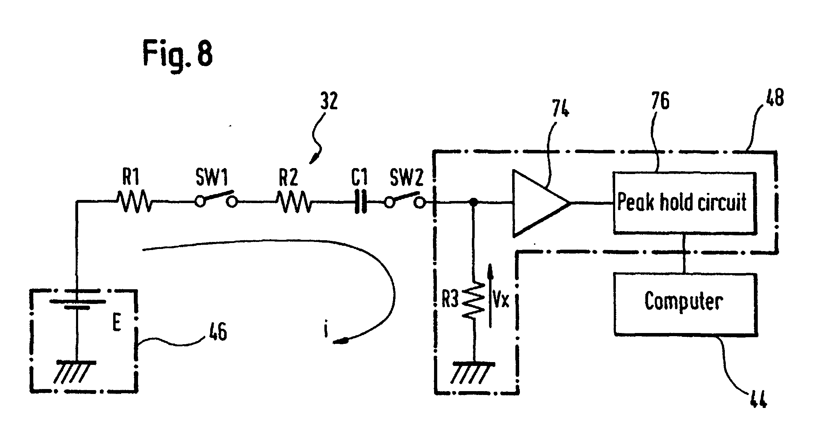

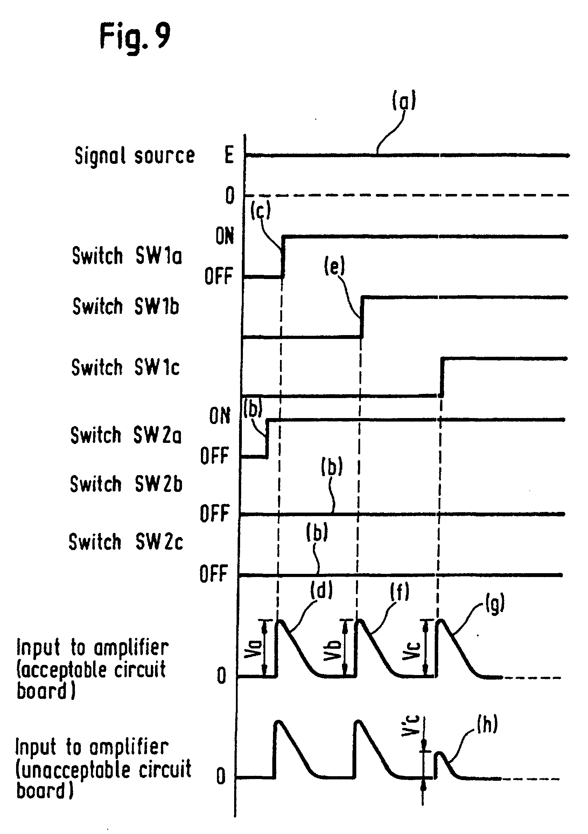

The signal processing executed by the bareboard tester shown in Figure 1 will be described. Figure 8 shows an equivalent circuit used for signal processing. Figure 9 is a timing chart showing signal processing. The signal processing executed by the bare-board tester will be described with reference to Figures 18 and 9. For ease of comprehension, Figure 9 omits the description of a few switches that constitute the switch sections SW1 and SW2.

This embodiment uses a constant voltage source as the signal source 46 (see (a) in Figure 9). Thus, a constant voltage E is applied to the switch SW1 by the signal source 46, as shown in Figure 1. The computer 44 first transmits an instruction to the switch section SW2 to turn on only the switch SW2a while turning the other switches SW2b, SW2c, and SW2d off (see Figures 7B and (b) in Figure 9). Then, only the sensor unit 52 is connected to the signal detection circuit 48, whereas the other sensor units 54, 56, and 58 remain disconnected from the signal detection 48.

The computer 44 then sends an instruction to the switch SW1 to turn on the switch SW1a (see (c) in Figure 9) while turning the other switches SW1b, SW1c, ... off (see Figure 7A). Then, only the probe 40a is connected to the signal source 46, whereas the probes 40b, 40c, ... remain disconnected from the signal source 46. This causes the printed pattern 34a on the circuit board 32 to be selected and inspected.

In this case, in Figure 8, a resistor R1 represents the internal resistance of the switches SW1a and SW2a, and a resistor R2 represents the resistance of the printed pattern 34a on the circuit board 32. A resistor R3 represents the ground resistance in the signal detection section 48. A capacitor C1 represents a capacitor formed of the electrode plates 62a, 62b, ... of the sensor unit 52, the insulating film 70 (see Figure 4B), and the pads 38a, 38b, ... corresponding to the sensor unit 52. E represents a direct voltage from the signal source 46.

When the switch SW 1a is turned on (see (c) in Figure 9), the equivalent circuit shown in Figure 8 is closed to allow a current (i) (shown below) to flow.

$$i = E / (R1 + R2 + R3) \cdot \exp(-\alpha t)$$

wherein

$$\alpha = 1 / \{(R1 + R2 + R3) \cdot C1\} \qquad (1)$$

Thus, a voltage Vx input to an amplifier 74 is:
Vx = R3 · i = R3 / (R1 + R2 + R3) y E · ·exp (- $\alpha$ t) wherein

$$\alpha = 1 / \{(R1 + R2 + R3) \cdot C1\} \qquad (2)$$

After the voltage Vx has been amplified by the amplifier 74, a peak hold circuit 76 detects and stores its maximum value (corresponding to the voltage Va in (d) in Figure 9). The peak hold circuit 76 includes a D/A converter (not shown) that digitalizes and transmits the maximum value to the computer 44. Part of the function of the peak hold circuit 76 can be implemented by the computer 44.

Based on the maximum value, the computer 44 determines the continuity of the printed pattern 34a on the circuit board 32. For example, it makes a determination by checking whether the maximum value is between the prescribed upper and lower reference limits.

As is apparent from Equation (2), the voltage Vx input to the amplifier 74 exhibits the maximum value Va (= R3 / (R1 + R2 + R3) · E) almost simultaneously with the activation of the switch SW1a (see (d) in Figure 9).

Thus, the peak hold circuit 76 can detect the maximum value in a very short time, which enables the continuity of the printed pattern to also be determined in a very short time. As a result, the operation is unlikely to be affected by noise.

The computer 44 then transmits an instruction to the switch SW1 to turn on the switch SW1b (see (e) in Figure 9). The switch SW1a remains on. Thus, the probes 40a and 40b are connected to the signal source 46. In this case, the condition of the switch section SW2 remains unchanged.

As described above, the voltage Vx input to the amplifier 74 exhibits a maximum value Vb (see (f) in Figure 9) almost simultaneously with the activation of the switch SW1b (see (e) in Figure 9). The computer 44 determines the continuity of the printed pattern 34b on the circuit board 32 based on the maximum value Vb, as described above.

In this case, although the printed pattern 34a on the circuit board 32 is selected along with the printed pattern 34b, at the time of the activation of the switch SW1b, the capacitor C1 (see Figure 8) in the equivalent circuit formed of the printed pattern 34a is almost fully charged (the timing with which the switch SW1b is activated is designed to realize this condition). Thus, virtually no current (i) flows through the printed pattern 34a. Consequently, the voltage Vx input to the amplifier 74 is provided only by the current (i) flowing through the printed pattern 34b.

In this embodiment, as described above, the sensor module 50 is composed of the plurality of sensor units 52, 53, ... (see Figure 2), each of which is coupled to the corresponding group of pads via the separate capacitor. Thus, the electrostatic capacity of each capacitor C1 is relatively small. That is, a shown in Equation (1) has a relatively large value (that is, the time constant correspondingly has a small value). Thus, the time (t) required until the current (i) falls close to zero is short, as is apparent from Equation (1). This embodiment can thus determine the continuity of the printed patterns in short cycles.

The computer 44 then activates of the switch sections SW1 and SW2 as required to inspect the continuity of the printed patterns 34c, ... If the circuit board 32 is acceptable as shown in Figure 9, that is, if the printed patterns 34a, 34b, 34c, ... are not open-circuited, the voltage Vx input to the amplifier 74 is as shown in (d), (f), (g),..., respectively.

On the other hand, if the circuit board 32 is unacceptable, for example, if the printed pattern 34c is open-circuited, then the voltage Vx input to the amplifier 74 has a very small maximum value V'c as shown in (h), thereby allowing the unacceptability of this circuit board to be determined easily. This is also indicated in Equation (2), wherein Vx = 0 is established regardless of the time (t) if the resistor R2 representing the resistance of the printed pattern has an infinite value (a completely open-circuit).

This embodiment can thus inspect the continuity of the printed pattern promptly and accurately.

Although this embodiment turns on the switch SW1b while holding the switch 1a on (see (c) and (e) in Figure 9), the switch SW1a may be turned off immediately after the peak hold circuit 76 has detected the maximum value for the printed pattern 34a (the maximum value corresponding to the voltage Va), followed by the turn-on of the switch SW1b. This configuration eliminates the need to wait for the current (i) flowing through the printed pattern 34a to fall close to zero before starting the inspection of the next printed pattern 34b. Thus, the continuity of the printed patterns can be inspected in shorter cycles. This configuration also prevents the length of the inspection cycle from being increased drastically even if the time constant (an inverse of $\alpha$ in Equations (1) and (2)) is large.

In addition, although the above embodiment uses the constant-voltage source as the signal source 46 (see (a) in Figure 9) and turns each switch of the switch section SW1 on/off (see (c) and (e) in Figure 9) to obtain a voltage with waveform-shaped steps and having sharp rising edges, a circuit that sequentially generates signals with rapid changes may be used as the signal source 46.

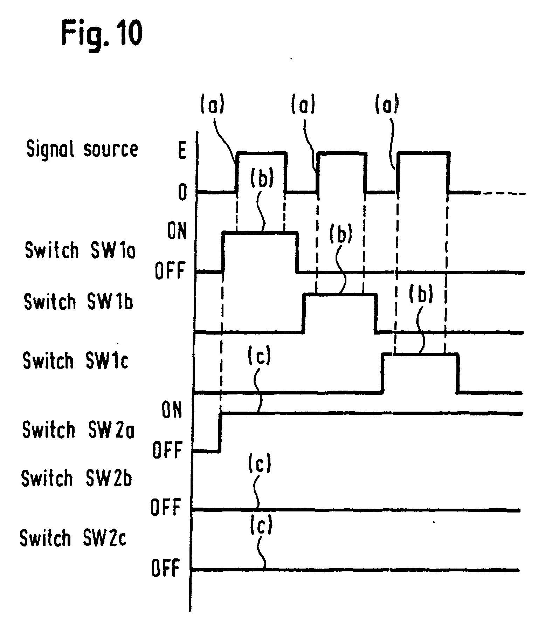

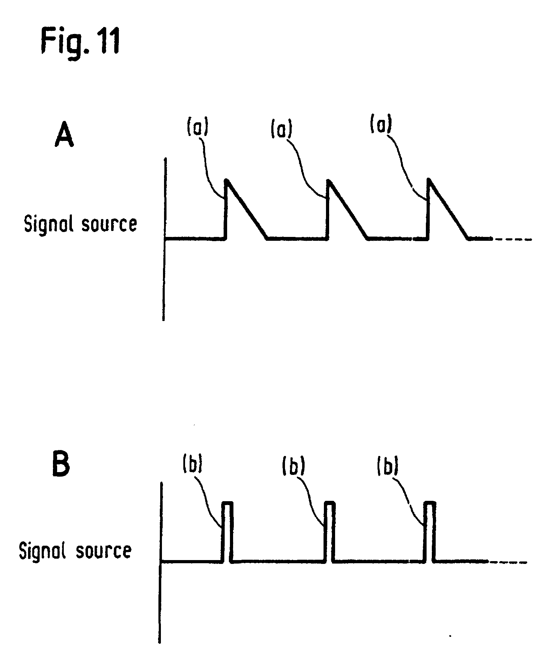

Figure 10 shows a timing chart of signal processing executed when the signal source 46 described above is used. This example employs a rectangular-wave generating circuit as the signal source 46. By activating the switch SW1 or SW2 simultaneously with the phase of the rising edge of each rectangular signal (see (a) in Figure 10), the computer 44 distributes among the printed patterns 34a, 34b, ... each rectangular signal sequentially generated by the signal source 46 (Figure 11). The condition of the voltage Vx input to the amplifier 74 and the processing executed after it has been input to the amplifier 74 are similar to those in the example shown in Figure 9.

Although, in the example shown in Figure 10, the signal source 46 generates rectangular waves, it may be configured to generate triangular waves as shown in Figure 11A. In this figure, each triangular wave has sharp rising edges (a). The signal source 46 may be configured to generate a pulse train as shown in Figure 11B. In this figure, each pulse signal has sharp rising edges (b), as in Figure 11A.

The signal having sharp rising edges is not limited to the ones described above. It includes not only those rising at time 0 but also those delaying rising. It also includes those having sharp falling edges.

Although the above embodiment determines the continuity of the wiring based on the maximum voltage generated at the second terminal after the signal has changed rapidly, this invention is not limited to this aspect. This invention may be configured to determine the continuity of the wiring based on a quantity relating to the voltage generated between the first and the second terminals when a signal with rapid changes are applied, such as the average of the voltage within a specified period of time, the voltage value obtained after a specified period of time, the steady-state deviation voltage, or the maximum, average, or integral value of the current flowing between the first and second terminals, all values obtained after the signal has changed rapidly. The continuity of the wiring, however, can be determined in a shorter time by using the maximum voltage as in the above embodiment.

Although the above embodiment has been described in conjunction with the sensor module composed of the plurality of second terminals (the sensor units 52, 54, 56, and 58), this invention is also applicable to a sensor module consisting of a single second terminal.

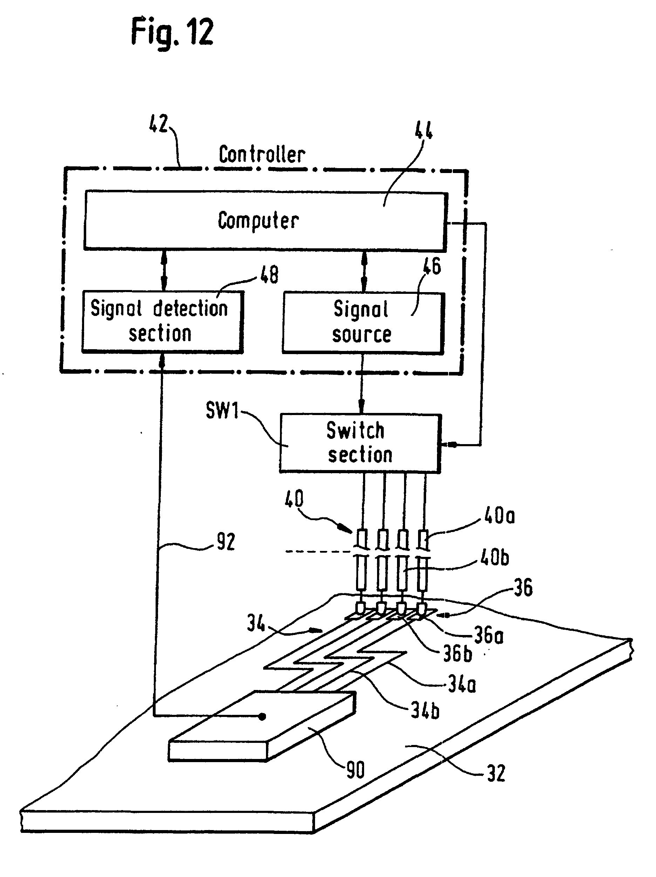

Figure 12 shows the configuration of a bareboard tester that uses a sensor module 90 composed of a single second terminal.

The configurations of the controller 42, the switch section SW1, and the probe section · 40 are similar to those in the bare-board tester shown in Figure 1. The bare-board tester shown in Figure 12, however, has only one output from the sensor module 90. Thus, it does not include the switch SW2 that switches the output from the sensor module 50 to supply it to the signal detection section 48, as in Figure 1.

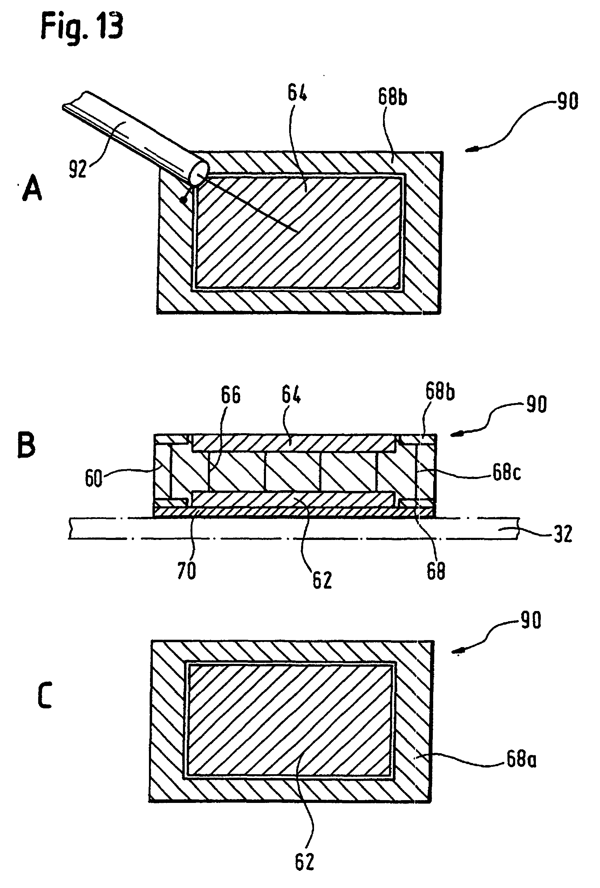

The sensor module 90 disposed on the pad section 38 (see Figure 2) of the circuit board 32 is coupled to the pad section 38 to obtain a signal therefrom in order to deliver directly it to the signal detection section 48. Figures 13A, 13B, and 13C show the configuration of the sensor module 90. The sensor module 90 is composed of a circuit board 60 (see Figure 13B) manufactured through a process similar to that for the inspected circuit board 32 as in the above embodiment.

Figure 13A is a plan view of the sensor module 90. Figure 13B is a cross sectional view of the integral part of the module. Figure 13C is a bottom view. As shown in Figures 13B and 13C, one electrode plate 62 that is the electrode section is provided on the bottom surface of the circuit board 60, with an insulating film 70 formed to cover the electrode plate 62. The electrode plate 62 is disposed opposite to the pad section 38 of the inspected circuit board 32 and is capacitively coupled to all the pads 38a, 38b, ... (see Figure 2) in the pad section 38 via the insulating film 70.

This configuration is convenient because the variation of the electrostatic capacity generated between the electrode plate 62 and the pads 38a, 38b, ... shown in Figure 2 is relatively small even if the plate is only roughly aligned with the pads.

A connection plate 64 is provided on the top surface of the circuit board 60, as shown in Figures 13A and 13B. The connection hole 64 is electrically connected to the electrode plate 62 via a through-hole 66. The connection plate 64 is connected to the signal detection section 48 via a connection cord 92.

In addition, as shown in Figures 13A, 13B, and 13C, shield films 68a and 68b, which are shield members, are formed on the bottom and the top surfaces of the circuit board 60, respectively, and connected to each other via a through-hole 68c. The shield films 68a and 68b are provided with a ground potential.

The signal processing executed by the bareboard tester shown in Figure 12 is almost the same as that by the bare-board tester shown in Figure 1. The bare-board tester shown in Figure 12, however, does not execute processing for the switch section SW2, as described above.

Part or all of the function of the computer 44 shown in Figure 1 or Figure 12 can also be implemented by hardware logic. In addition, part or all of the function of the signal source 46 or the signal detection section 48 can also be implemented by the computer.

Although the above embodiment disposes shield members around the electrode section, the shield members may be eliminated. The use of the shield members, however, can reduce noise.

In addition, although the above embodiment provides the insulating film on the second terminal covering the electrode section, the insulating film may be eliminated. Providing the insulating film on the second terminal, can facilitate prompt inspections because it there is no need to prepare separate insulating films prior to inspection.

In addition, although the above embodiment provides the electrode section on one side of the circuit board constituting the sensor module while providing on the other side the connection conducting section electrically connected to the electrode section, the connection conducting section on the other side may be eliminated. By providing the connection conducting section on the other side, however, the structure of the sensor module can be simplified because a signal can be transmitted easily via this section.

In addition, although, in the above embodiment, the sensor module is composed of the circuit board that is manufactured through a process similar to that used for the inspected circuit board, it may be made of a circuit board that is manufactured through a process dissimilar to that used for the inspected circuit board or may be configured without a circuit board. By manufacturing the sensor module through a process similar to that used for the inspected circuit board, however, if the density or complicatedness of the wiring on the inspected circuit board has been increased, the density or complicatedness of the sensor module can be conveniently increased accordingly.

In the above embodiment, the second terminal is capacitively coupled to the other end of the wiring. The capacitive coupling enables reliable inspections to be conducted using a simple configuration.

The above embodiment provides the plurality of first terminals and uses the first switch means to select a desired first terminal in order to select one of the one ends of the wiring on the inspected circuit board. This configuration eliminates the need to move the inspected circuit board relative to the first terminal, thereby enabling inspections to be conducted very accurately, reducing the manufacturing cost of the apparatus, and allowing simple automation of inspections.

In addition, although the above embodiment has been described in conjunction with the inspected circuit board having wiring with a plurality of other ends connected together, this invention is not limited to the inspection of such a circuit board.

In addition, although the above embodiment has been described in conjunction with the bare-board tester, this invention is not limited to such a tester. This invention is also applicable to general circuit board inspection apparatuses and methods such as those for inspecting a circuit board on which circuit elements such as a CPU are mounted or a package on which circuit elements are mounted.

**Claims**

1. A circuit board inspection apparatus for inspecting wirings (34a, 34b...) formed on a circuit board (32), comprising:

   a plurality of first terminals (40a, 40b...) to be respectively in contact with and electrically connected with ends (36a, 36b....) of said wirings,

   a signal supplier (46,SW1) for selectively supplying, to each of said first terminals, a predetermined test signal,

   a second terminal (52, 54, 56, 58) which is to face with a gap and capacitively coupled with the other ends of said wirings in order to receive the test signal transmitted through said capacitive coupling, and

   a detector (48) for detecting continuity of the wiring which is supplied with the test signal,

   **characterized in that**
   said test signal supplied to the first terminals (40a, 40b...) has a sharp rising or falling edge, and
   said detector is arranged to detect the continuity of said wirings in accordance with the maximum value of the test signal received by the second terminal (52, 54, 56, 58), said maximum value being associated with said rising or falling edge.

2. A circuit board inspection apparatus according to claim 1, **characterized in that** the signal supplier includes a constant voltage source (46) and a switch (SW1) for selectively connecting the voltage source (46) with one of the first terminals (40a, 40b, ...) wherein the sharp rising or falling edge is generated upon switching of the switch (SW1).

3. A circuit board inspection apparatus according to claim 1, **characterized in that** the signal supplier includes a generator for generating a rectangular wave form signal.

4. A circuit board inspection apparatus according to any one of claims 1 to 3, **characterized by** a peak hold circuit (76) for holding the maximum value of the test signal received by the second terminal.

5. A circuit board inspection apparatus according to any one of claims 1 to 4, **characterized by** an electrically insulating film (70) interposed between the second terminal and the circuit board to be inspected.

6. A circuit inspection apparatus according to any one of claims 1 to 5, **characterized by** a shield member provided around the second terminal.

7. A circuit board inspection apparatus according to any one of claims 1 to 6, **characterized by** a plurality of second terminals (52, 54, 56, 58), each of which faces and is capacitively coupled with a plurality of ends of wirings.

**Patentansprüche**

1. Leiterplattenprüfvorrichtung zum Prüfen von auf einer Leiterplatte (32) gebildeten Leitungen (34a, 34x), umfassend:

  eine Vielzahl von ersten Anschlüssen (40a, 40b...), die jeweils mit Enden (36a, 36b...) der Leitungen in Kontakt zu bringen und elektrisch zu verbinden sind,

  eine Signalquelle (46, SW1) um jedem der ersten Anschlüsse selektiv ein vorbestimmtes Testsignal zuzuführen,

  ein zweiter Anschluss (52, 54, 56, 58), der über eine Lücke den anderen Enden der Leitungen gegenüberstehen soll und mit ihnen kapazitiv gekoppelt sein soll, um über die kapazitive Kopplung das übertragene Testsignal zu empfangen, und

  einen Detektor (48) zur Erfassung der Durchgängigkeit der Leitung, der das Testsignal zugeführt wird,

  **dadurch gekennzeichnet, dass**
  das den ersten Anschlüssen (40a, 40b...) zugeführte Testsignal eine steile ansteigende oder abfallende Flanke hat, und
  der Detektor angeordnet ist, um die Durchgängigkeit der Leitungen in Übereinstimmung mit dem Maximalwert des vom zweiten Anschluss (52, 54, 56, 58) empfangenen Testsignals zu erfassen, wobei der Maximalwert in Beziehung steht mit der ansteigenden oder abfallenden Flanke.

2. Leiterplattenprüfvorrichtung nach Anspruch 1, **dadurch gekennzeichnet, dass** die Signalquelle eine Konstantspannungsquelle (46) und einen Schalter zum selektiven Verbinden der Spannungsquelle (46) mit einem der ersten Anschlüsse (401, 40b,...) enthält, wobei die steile ansteigende oder abfallende Flanke beim Schalten des Schalters (SW1) erzeugt wird.

3. Leiterplattenprüfvorrichtung nach Anspruch 1, **dadurch gekennzeichnet, dass** die Signalquelle einen Generator zur Erzeugung eines Rechtecksignals enthält.

4. Leiterplattenprüfvorrichtung nach einem der Ansprüche 1 bis 3, **gekennzeichnet durch** eine Spitzenhaltschaltung (76) zum Halten des Maximalwerts des vom zweiten Anschluss empfangenen Testsignals.

5. Leiterplattenprüfvorrichtung nach einem der Ansprüche 1 bis 4, **gekennzeichnet durch** einen elektrisch isolierenden Film (70), der zwischen dem zweiten Anschluss und der zu prüfenden Leiterplatte eingefügt ist.

6. Leiterplattenprüfvorrichtung nach einem der Ansprüche 1 bis 5, **gekennzeichnet durch** ein um den zweiten Anschluss vorgesehenes Abschirmglied.

7. Leiterplattenprüfvorrichtung nach einem der Ansprüche 1 bis 6, **gekennzeichnet durch** eine Vielzahl von zweiten Anschlüssen (52, 54, 56, 58), jeder von welchen einer Vielzahl von Leitungsenden gegenübersteht und mit ihnen kapazitiv gekoppelt ist.

**Revendications**

1. Un appareil d'inspection de carte de circuit pour inspecter des pistes (34a, 34b, ...) formées sur une carte de circuit (32), comprenant :

  une multiplicité de premières bornes (40a, 40b, ...) destinées à être respectivement en contact et en connexion électrique avec des extrémités (36a, 36b, ...) de ces pistes,
  un dispositif d'application de signal (46, SW1) pour appliquer sélectivement à chacune des premières bornes un signal de test prédéterminé,
  une seconde borne (52, 54, 56, 58) qui est destinée à faire face, avec un espace, aux autres extrémités des pistes, en couplage capacitif avec celles-ci, afin de recevoir le signal de test transmis par le couplage capacitif, et
  un détecteur (48) pour détecter la continuité de la piste qui reçoit le signal de test,

**caractérisé en ce que**

le signal de test appliqué aux premières bornes (40a, 40b, ...) a un front montant ou descendant abrupt, et

le détecteur est adapté pour détecter la continuité des pistes conformément à la valeur maximale du signal de test reçu par la seconde borne (52, 54, 56, 58), cette valeur maximale étant associée au front montant ou descendant.

2.  Un appareil d'inspection de carte de circuit selon la revendication 1, **caractérisé en ce que** le dispositif d'application de signal comprend une source de tension constante (46) et un commutateur (SW1) pour connecter sélectivement la source de tension (46) à l'une des premières bornes (40a, 40b, ...), le front montant ou descendant abrupt étant généré au moment de la commutation du commutateur (SW1).

3.  Un appareil d'inspection de carte de circuit selon la revendication 1, **caractérisé en ce que** le dispositif d'application de signal comprend un générateur pour générer un signal de forme d'onde rectangulaire.

4.  Un appareil d'inspection de carte de circuit selon l'une quelconque des revendications 1 à 3, **caractérisé par** un circuit de blocage de valeur de crête (76) pour bloquer la valeur maximale du signal de test reçu par la seconde borne.

5.  Un appareil d'inspection de carte de circuit selon l'une quelconque des revendications 1 à 4, **caractérisé par** une pellicule électriquement isolante (70) interposée entre la seconde borne et la carte de circuit à inspecter.

6.  Un appareil d'inspection de carte de circuit selon l'une quelconque des revendications 1 à 5, **caractérisé par** un élément de blindage placé autour de la seconde borne.

7.  Un appareil d'inspection de carte de circuit selon l'une quelconque des revendications 1 à 6, **caractérisé par** une multiplicité de secondes bornes (52, 54, 56, 58), chacune d'elles faisant face à une multiplicité d'extrémités de pistes, et étant en couplage capacitif avec celles-ci.

## Fig. 1

Fig. 2

# Fig. 3

A

54

64

56

52

50

58

72

B

54

56

52

50

58

62a

62b

# Fig. 4

# Fig. 5

**A**

52
72

**B**

52
60
62

**C**

52
62

# Fig. 6

A

64a  64b  52

B

64a  64b  52
60
66a
66b
62a  62b

C

52
62a  62b

# Fig. 7

**A**

To signal source 46

SW1b

SW1a

SW1c

SW1

To probe section 40

**B**

To signal detection section 48

SW2d

SW2b

SW2c

SW2a

SW2

To sensor module 50

Fig. 8

# Fig. 9

# Fig. 10

## Fig. 11

A

Signal source

(a)  (a)  (a)

B

Signal source

(b)  (b)  (b)

## Fig. 12

# Fig. 13

A

B

C

Fig. 14

# Fig. 15